# EUROPÄISCHE PATENTSCHRIFT

(11) **EP 0 783 702 B1**
(45) Veröffentlichungstag und Bekanntmachung des Hinweises auf die Patenterteilung: **12.05.1999**
(21) Anmeldenummer: 95928989.3
(22) Anmeldetag: 26.08.1995
(51) Int. Cl.: G01R 27/16

(54) **VERFAHREN UND VORRICHTUNG ZUR IMPEDANZMESSUNG IN WECHSELSTROMNETZEN SOWIE VERFAHREN UND VORRICHTUNG ZUR VERHINDERUNG VON INSELNETZEN**
METHOD AND DEVICE FOR MEASURING IMPEDANCE IN ALTERNATING CURRENT NETWORKS AND METHOD AND DEVICE FOR PREVENTING THE FORMATION OF SEPARATE NETWORKS
PROCEDE ET DISPOSITIF DE MESURE D'IMPEDANCE DANS DES RESEAUX A COURANT ALTERNATIF, AINSI QUE PROCEDE ET DISPOSITIF POUR EMPECHER LA FORMATION DE RESEAUX SEPARES

(30) Priorität: 29.09.1994 DE 4434874; 09.02.1995 DE 19504271
(43) Veröffentlichungstag der Anmeldung: 16.07.1997
(73) Patentinhaber: Köln, Klaus-Wilhelm, D-39615 Wanzer (DE)
(72) Erfinder: Köln, Klaus-Wilhelm, D-39615 Wanzer (DE)
(74) Vertreter: Kuczka, Detlef Dr., Dipl.-Ing.
(86) Internationale Anmeldenummer: DE9501141
(87) Internationale Veröffentlichungsnummer: WO9610188

(56) Entgegenhaltungen:
- DE-A- 3 600 770
- DE-B- 1 035 760
- DE-B- 1 237 218
- DE-B- 1 257 960
- FR-A- 2 498 762

## Beschreibung

Die unbeabsichtigte Bildung von spannungsführenden Inselnetzen soll dadurch verhindert werden, daß eine oder mehrere Einrichtungen zur Netzüberwachung mit zugeordneten Schaltorganen eine in das Netz Energie einspeisende Einrichtung vom Netz trennt oder anderweitig außer Betrieb setzt, wenn ein kleiner Teil des Netzes, an dem die einspeisende Einrichtung angeschlossen ist, vom Hauptnetz getrennt wird.

Aus der DE - AS 10 35 760 ist ein Gerät zur Bestimmung der Kurzschluß - Stromstärke in elektrischen Leitungsnetzen bekannt, bei dem ein Netzbelastungswiderstand für eine kurzzeitige Netzspannungsabsenkung dient und bei dem die Differenzspannung aus der Netzspannung bei Ein- und Abschaltung des Widerstandes ein Kriterium für die gesuchte Größe ist. Ein Synchronschalter schaltet den Widerstand mit einer von den Netzperioden abhängigen Häufigkeit abwechselnd zu und ab. Der Ein- und Abschaltpunkt wird jeweils in einen Nulldurchgang der Spannung gelegt. Die Differenz der Spannungen bei ein- und abgeschalteten Widerstand gelangt zur Anzeige. Der Belastungswiderstand kann wahlweise ein ohmscher oder ein Blindwiderstand sein. Eine Bestimmung bzw. Messung der Impedanz in Wechselstromnetzen ist nicht vorgesehen.

Die DE - AS 1 257 960 zeigt eine Schaltung zur Messung der Netz - Innenimpedanz eines Wechselstrom - Versorgungsnetzes auf, bei der die durch eine zusätzliche Netzbelastung bewirkte Spannungsabsenkung als Maß für die gesuchte Größe dient. Gemessen wird eine Spannungsdifferenz zwischen dem belasteten und dem unbelasteten Zustand. Die Messung soll bei einem bestimmten Meßwinkel erfolgen. Der Meßwinkel wird bezüglich der Netzspannung immer konstant gehalten. Die Festlegung des Meßwinkels, bei dem die arithmetische Differenz beider Spannungen möglichst der geometrischen und damit der tatsächlichen Netz- Innenimpedanz entspricht, soll durch Berechnung oder Messung ermittelt werden. Da in der Praxis die Ermittlung jedoch mit vertretbarem Aufwand zumeist nicht möglich ist, wird ein fest eingestellter Meßwinkel vorgeschlagen.

Aus der DE 36 00 770 A1 ist ein Meßverfahren zur Ermittlung der betriebsfrequenten Netzimpedanz eines Hochspannungsnetzes mit Hilfe einer Transformatorschaltung bekannt. Aus den mit der Transformatorschaltung verbundenen Spannungs- und Stromänderungen in dem Hochspannungsnetz wird die betriebsfrequente Netzimpedanz berechnet. Bei der Auswertung müssen die betriebsfrequenten Anteile von Spannung und Strom für alle Phasen des Drehstromsystems ermittelt werden. Danach muß eine Transformation in symmetrische Komponenten erfolgen.

Die Division von betriebsfrequenter Spannungs- und Stromänderung, für Mit-, Gegen- und Nullsystem getrennt, ergeben die gesuchten betriebsfrequenten Netzimpedanzen.

Weiterhin sind Einrichtungen bekannt, die die Spannung in einem Netz überwachen und beim Über- oder Unterschreiten von Grenzwerten eine Abschaltung der Energieeinspeisung auslösen.

Bei Wechselstromnetzen sind weiterhin Einrichtungen bekannt, die Netzfrequenz oder Phasenlage der drei Phasen im Drehstromnetz überwachen und bei einer Über- oder Unterschreitung vorgegebener Grenzen eine Abschaltung auslösen.

Auch sind für Wechselstromnetze Verfahren bekannt, bei denen das einspeisende Gerät im Fall einer Teilnetzabtrennung die Netzfrequenz zu verändern versucht und eine Frequenzüberwachungsschaltung diese Änderung erkennen soll.

Ein anderes Verfahren wertet den typischen Anstieg der Netzoberwellen bei einer Netzabtrennung aus.

Diese Verfahren bzw. Vorrichtungen haben gemeinsam, daß die Inselbildung nicht zuverlässig erkannt wird:

In dem Fall, daß in dem abzutrennenden Teilnetz, in dem eine Stromeinspeisung stattfindet, auch Strom verbrauchende Geräte angeschlossen sind, die gerade soviel Strom verbrauchen, wie in dem Strom einspeisenden Gerät gerade dem Teilnetz zugeführt wird, ist in der Koppelstelle zum Hauptstromnetz kein Stromfluß festzustellen. Bei dieser Konstellation tritt bei dem Auftrennen der Koppelstelle eine Inselbildung auf, die von den bekannten Verfahren nicht erkannt wird, da bei der Aufrechterhaltung des Gleichgewichtszustandes von Einspeisung und Verbrauch kaum eine Spannungs- oder Frequenzänderung erfolgt. Beispielsweise versagen die bekannten Verfahren bei netzeinspeisenden Photovoltaikwechselrichtern, wenn ein Stromkreis im wesentlichen in Bezug auf Einspeisung und Verbrauch - auch unter Berücksichtigung von Blindströmen - aufeinander abgestimmt ist und dann vom Hauptnetz getrennt wird. Es besteht die Gefahr, daß in solch einem Fall auch über längere Zeit die Spannung im Inselnetz aufrechterhalten wird.

Dies führt in der Praxis zu einem Sicherheitsproblem:

Treten diese Gleichgewichtsbedingungen zufällig auf steht das Teilnetz, trotz Abschaltung dieses Teilnetzes vom Hauptnetz, weiterhin unter Spannung. Eine an dem Teilnetz arbeitende Person aber geht davon aus, daß nach Abschaltung des Teilnetzes dieses spannungsfrei ist.

Der vorliegenden Erfindung liegt daher das Problem zugrunde, ein Verfahren und eine Vorrichtung aufzuzeigen, mit der eine Bestimmung einer Impedanz durchgeführt werden kann. Weiterhin soll ein Verfahren und eine Vorrichtung aufgezeigt werden, bei dem zuverlässig bei dem Abschalten eines Teilnetzes von einem Hauptnetz die in dem Teilnetz angeschlossenen energieeinspeisenden Geräte automatisch abgeschaltet werden, um eine Spannungsfreiheit herzustellen.

Erfindungsgemäß wird das Problem bezüglich des Verfahrens zur Bestimmung der Impedanz durch die Merkmale des Anspruchs 1, der Vorrichtung zur Bestimmung der Impedanz durch die Merkmale des Anspruchs 9, des Verfahrens zur Verhinderung von Inselnetzen durch die Merkmale des Anspruchs 8 und der entsprechenden Vorrichtung durch die Merkmale des Anspruchs 10 gelöst.

Es wird von der Überlegung ausgegangen, daß auch für den Fall des Gleichgewichtes zwischen Einspeisung und Verbrauch im Teilnetz eine Abtrennung vom Hauptnetz erkennbar sein muß.

In Verbindung mit einem Strom einspeisenden Gerät läßt sich eine Meß- und Überwachungseinrichtung derart realisieren, indem die Netzimpedanz als Überwachungsfunktion gewählt wird.

Das einspeisende Gerät soll auch bei gleichbleibender Eingangsleistung keine gleichbleibende Ausgangsleistung an das Netz abgeben, sondern die Leistungsabgabe verändert sich. Die daraus folgende Spannungsänderung wird gemessen.

Diese Spannungsänderung ist proportional zur Netzimpedanz. Wird ein Teilnetz abgetrennt, in dem das einspeisende Gerät einen großen Anteil der gerade umgesetzten Leistung liefert, ist die Netzimpedanz mehrfach höher als im normalen Stromnetz.

Als Folge der Leistungsänderung des Einspeisers sind entsprechend größere Spannungsänderungen im Inselnetz zu messen.

Damit bei gleichbleibender Eingangsspannung die Ausgangsleistung eines Gerätes geändert werden kann, muß in der Regel Energie in einem Kondensator zwischengespeichert oder aus ihm entnommen werden.

Der gleiche Effekt läßt sich auch durch kurzes Zuschalten einer zusätzlichen Last erreichen. Dadurch treten zwar zusätzliche Verluste auf, es ist aber eine weitgehende Unabhängigkeit gegeben.

Um die notwendige Größe des Kondensators bzw. der zusätzlichen Verluste zu begrenzen, sollte nur ein kurzer Impuls mit geänderter Leistung erzeugt und die resultierende Spannungsänderung gemessen werden.

Die Impulserzeugung und Messung kann in sinnvollen Abständen, die kleiner als die zulässige Abschaltdauer sein sollten, wiederholt werden.

Um störende Netzrückwirkungen zu vermeiden, kann dieser Puls bei Wechselspannungsnetzes als Vollwelle oder Vollwellenpaket ausgeführt sein.

Anstelle einer Leistungserhöhung oder -reduzierung kann die Einspeisung auch ganz unterbrochen werden.

Es findet somit eine automatische Überwachung von Stromnetzen, in denen an mehreren Stellen Energie zugeführt wird statt, wobei das Abtrennen eines Teilnetzes, in dem Strom eingespeist wird, erkannt wird. Ein Gleichgewichtszustand zwischen Energieeinspeisung und Verbrauch, der in dem einen Teilnetz schwer zu erkennen ist, wird durch Leistungsvariation des Einspeisers vermieden. Gemessen werden die durch die Leistungsvariation entstehenden Spannungsänderungen oder Spannungsunterschiede. Das Energie einspeisende Gerät verändert auch bei gleichbleibender Eingangsleistung die an das Netz abgegebene Leistung selbständig. Erzeugt werden Pulse mit höherer Leistung, aber auch solche mit niedrigerer Leistung sind denkbar. Es können auch Pulse erzeugt werden, bei denen die Einspeisung unterbrochen wird. Im einspeisenden Gerät kann kurzzeitig eine Last zugeschaltet werden. Bei Wechselspannungsnetzen können die Pulse als Vollwelle, und / oder auch Vollwellenpakete erzeugt werden.

Bei dem Verfahren, bei dem die Netzimpedanz durch Belastung des Netzes mit Widerständen und Vergleich der Spannung des belasteten Netzes mit der des unbelasteten Netzes durchgeführt wird, tritt ein relativ hoher Energieverbrauch pro Prüfimpuls auf. Auch ist eine Spannungsmessung erforderlich. Der Stromverbrauch ist besonders dann relevant, wenn eine dauernde Überwachung durchgeführt werden soll. Weiterhin besteht die Gefahr, daß die Belastung des Netzes mit Wirkleistungsimpulsen zu Flickerstörungen führt. Auch die Wärmeentwicklung und das damit einhergehende große Bauvolumen der Geräte ist nicht wünschenswert.

Die Erfindung schlägt daher vor, daß ein Blindstrom erzeugt wird. Die Erzeugung des Blindstromes erfolgt in Intervalle. Gemessen wird die Phasenverschiebung der Spannung ohne Blindstrom zu der Spannung mit Blindstrom. Aus dieser Phasenverschiebung wird dann die Netzimpedanz bestimmt. Da es sich um Blindstrom handelt, ist keine nennenswerte Leistung erforderlich; der Energieverbrauch ist entsprechend gering. Dadurch wird eine dauernde schnelle Folge von Meßimpulsen auch bei kleinem Bauvolumen ermöglicht. Der Effektivwert der Spannung des Netzes bleibt im wesentlichen auch bei relativ hohen Strömen unverändert, so daß keine Flickerstörungen auftreten. Durch die Möglichkeit, hohe Ströme einzusetzen und gleichzeitig häufig zu messen und Mittelwerte zu bilden, wird eine hohe Meßgenauigkeit erreicht.

Der Blindstrom kann durch eine parallele Einschaltung einer Kapazität oder Induktivität zum Wechselstromnetz erzeugt werden. Die Kapazität oder Induktivität weist dann einen maximalen Strom auf, wenn die Netzspannung sich im Nulldurchgang befindet. Die Einschaltdauer der Kapazität bzw. der Induktivität sollte im wesentlichen einer Spannungsperiode entsprechen. Dadurch wird erreicht, daß die Schaltverluste minimiert werden.

Die Ermittlung der Phasenverschiebung zur Berechnung der Impedanz kann durch eine Zeitmessung erfolgen.

Die Dauer der Zeitmessung kann eine halbe Periode der Netzspannung betragen. Zur Bestimmung der Impedanz sind zwei Zeitmessungen vorgesehen, die in der Nähe des Spannungsnulldurchganges beginnen bzw. enden können. Direkt im Spannungsnulldurchgang ergibt sich eine maximale Auflösung. Die Zeitmessungen sollten daher in einem Bereich der Netzspannung von U = -50 V bis U = +50 V erfolgen.

Die erste Zeitmessung kann in der Nähe eines Spannungsnulldurchganges bei einer Spannung von U = +x V bei abgeschaltetem Blindstrom beginnen, wobei nach dem Beginn der ersten Zeitmessung der Blindstrom zugeschaltet wird. Die Zuschaltung bleibt bis zur Beendigung der ersten Zeitmessung aufrechterhalten. Nach einer halben Periode mit Erreichen der Spannung U = -x V wird dann die erste Zeitmessung beendet.

Die zweite Zeitmessung kann in der Nähe eines Spannungsnulldurchganges bei einer Spannung von U = +y V bei zugeschaltetem Blindstrom beginnen. Nach dem Beginn der zweiten Zeitmessung wird der Blindstrom abgeschaltet. Die Abschaltung bleibt bis zum Ende der zweiten Zeitmessung aufrechterhalten. Die zweite Zeitmessung wird nach einer halben Periode mit Erreichen der Spannung U = -y V beendet.

Die Zeitdifferenz der ersten und zweiten Zeitmessung kann als Maß der Impedanz benutzt werden. Durch diesen Meßvorgang mit anschließender Differenzbildung tritt eine Verdopplung der Zeitdifferenz auf, wodurch die Meßgenauigkeit wesentlich erhöht wird.

Gemäß der Lehre der Erfindung wird zur Belastung des Netzes eine Kapazität oder Induktivität benutzt, um einen Blindleistungsimpuls zu erzeugen. Der Blindleistungsimpuls führt zu einem Stromfluß und damit zu einem Spannungsabfall auch am Innenwiderstand des Netzes. Dieser erreicht gerade im Spannungsnulldurchgang seinen maximalen Wert und ist auch meßbar, wenn genau zu dem Zeitpunkt gemessen wird, bei dem der Spannungsnulldurchgang zu erwarten wäre. Einfacher und zuverlässiger ist die hier vorgeschlagene Zeitmessung, bei der die zeitliche Verschiebung des meßbaren Nullpunktes festgestellt wird. Diese Verschiebung ist annähernd linear abhängig von der Größe des Blindstromes und der Netzimpedanz, so daß eine einfache Auswertung möglich ist. Auch wird das Verfahren weniger durch Schaltvorgänge gestört, da das Schalten von Wirkleistungen nicht zu einer Verschiebung des Spannungsnulldurchganges führt.

Im folgenden wird die Erfindung anhand eines Ausführungsbeispiels näher erläutert.

Es zeigen
- Figur 1: ein Prinzipbild einer Netzüberwachungsschaltung und
- Figur 2: eine schematische Darstellung wichtiger Meßgrößen.

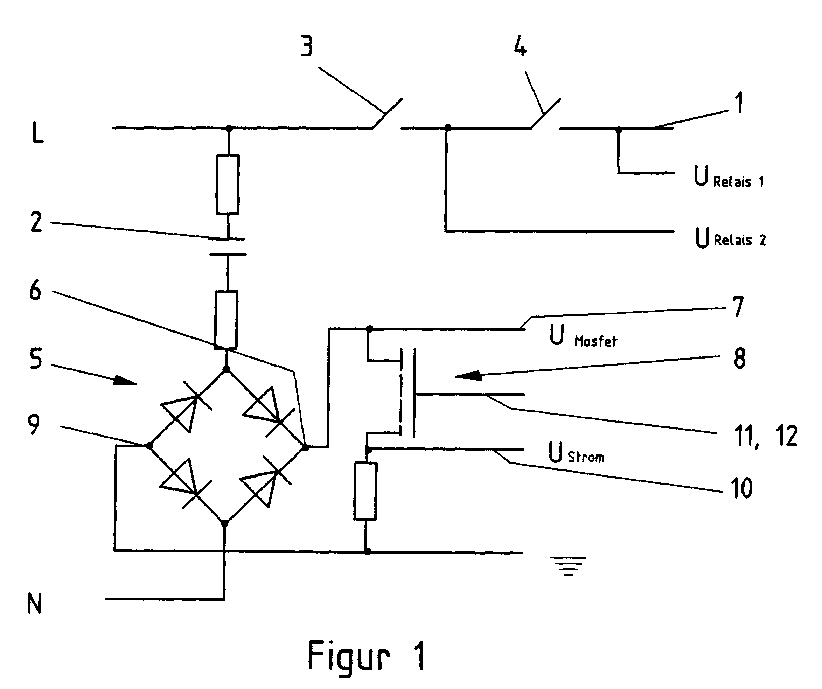

In der Figur 1 ist ein Prinzipdarstellung einer Schaltung dargestellt. Ein zu überwachendes Teilnetz 1 weist im wesentlichen einen Kondensator 2 auf, der parallel zu dem Teilnetz 1 geschaltet ist.

In Reihe mit dem Teilnetz 1 ist ein zweites Relais 3 und ein erstes Relais 4 vorgesehen. Zwischen dem zweiten Relais 3 und dem ersten Relais 4 wird die Spannung des zweiten Relais 3 abgenommen und einem hier nicht weiter dargestellten ersten und zweiten Mikrocontroller zugeführt. Von diesen beiden Mikrocontrollern wird ebenso die Spannung des ersten Relais 4 erfaßt.

Ein Gleichrichter 5, der dem Kondensator 2 nachgeschaltet ist, ist ausgehend von einem Punkt 6 mit Eingängen 7 der beiden Mikrocontroller verbunden. Die Spannung des Gleichrichterpunktes 6 wird weiterhin zu einem Schaltorgan 8 geleitet. Das Schaltorgan 8 ist ebenfalls mit dem Punkt 9 des Gleichrichters und mit den Eingängen 10 der beiden Mikrocontroller verbunden.

Die andere Seite des Schaltorganes 8 steht in Verbindung mit dem Ausgang 11 des ersten Mikrocontrollers und dem Eingang 12 des zweiten Mikrocontrollers.

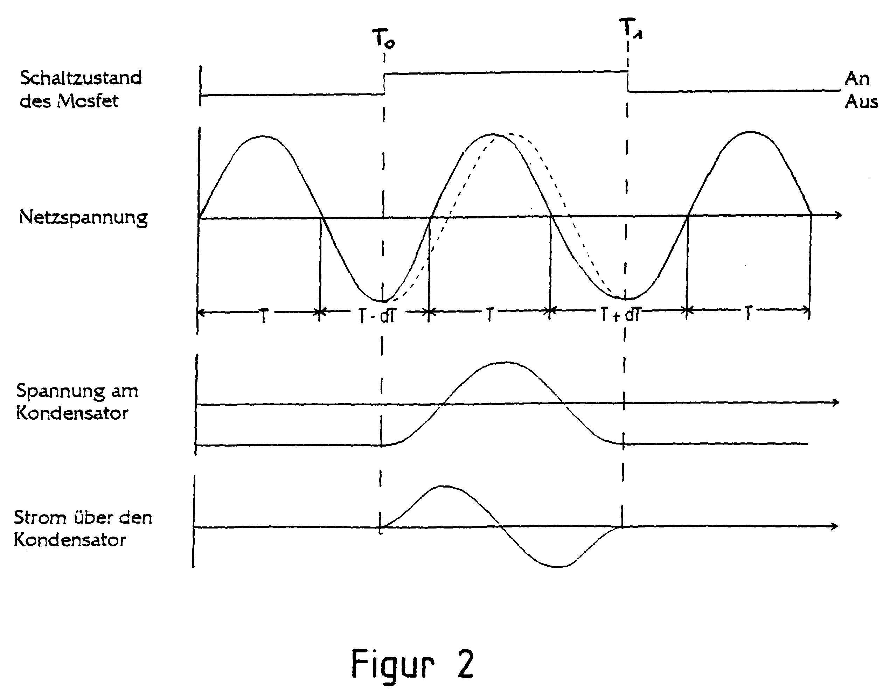

In der Figur 2 sind von oben nach unten auf der Ordinate ein Schaltzustand eines Schalters, eine Netzspannung, eine Spannung an einem Kondensator und ein Strom über den Kondensator eingezeichnet. Als Abszisse ist eine Zeitachse dargestellt.

Ausgehend von der Netzspannung wird der Kondensator zu einem Zeitunkt T₀ eingeschaltet. Zu diesem Zeitpunkt hat die sinusförmige Netzspannung ein Minimum. Die gestrichelte Linie zeigt die Netzspannung, wie sie ohne Belastung des Netzes aussehen würde.

Nach dem Einschalten des Schalters zum Zeitpunkt T₀ baut sich eine Spannung am Kondensator auf, die über eine ganze Periode der Netzspannung aufrechterhalten wird. Das Maximum der Kondensatorspannung wird im wesentlichen zu einem Zeitpunkt erreicht, zu dem auch die Netzspannung ihr Maximum erreicht. Danach baut sich die Kondensatorspannung wieder ab, bis zu dem Zeitpunkt T₁ der Schalter abgeschaltet wird und die Kondensatorspannung wie auch der Kondensatorstrom den Wert Null beträgt.

Die Zeitpunkte T₀ und T₁ befinden sich im Bereich je eines Minimums der Netzspannung, die Zeitdifferenz ist eine Periode.

In diesem Zeitintervall verhält sich der Strom über den Kondensator sinusförmig mit einer Frequenz von ebenfalls einer Periode.

Die Zeit T ist die Dauer einer Halbwelle, dT ist die zeitliche Verschiebung des Nulldurchganges durch den Spannungsabfall an der Netzimpedanz.

Unter der näherungsweisen Annahme, daß der Strom I um den Nulldurchgang konstant ist, und daß der Spannungsverlauf im Nulldurchgang linear verläuft, ist der Netzinnenwiderstand proportional zur Zeitdifferenz dT und umgekehrt proportional zum Strom I: R_{Netz} ≈ dt/I.

Im folgenden wird die Funktion näher erläutert.

Wird die Kapazität parallel zum Wechselstromnetz geschaltet, so fließt während der Nulldurchgänge des Netzes ein Blindstrom. Aus dem daraus resultierenden Spannungsabfall an der Netzimpedanz findet der Nulldurchgang in Relation zum unbelasteten Netz zeitverschoben statt. Aus dem Zeitunterschied zwischen dem Auftreten des Nulldurchganges im belasteten und unbelasteten Fall wird die Netzimpedanz bestimmt.

Die Zeitmessung beginnt bei einer Spannung U = x V. Irgendwann, vorteilhafterweise in der Nähe eines Nulldurchganges der Spannung, erfolgt die Zuschaltung des Blindstromes. Nach Ablauf einer halben Periode, wenn die Spannung U = -x V erreicht ist, endet die erste Zeitmessung. Der Blindstrom ist zu dieser Zeit noch immer zugeschaltet. Die zweite Zeitmessung wird bei einer Spannung U = y V begonnen. Während dieser Zeitmessung wird der Blindstrom abgeschaltet. Das Ende der zweiten Zeitmessung erfolgt nach einer halben Periode, wenn die Spannung U = -y V beträgt.

Aus diesen beiden Zeitmessungen wird die Differenz gebildet. Dadurch ergibt sich eine Verdoppelung der Zeitverschiebung, die als Maß der Impedanz genommen wird.

Zur Verhinderung von unkontrollierten Inselnetzen wird die Impedanz überwacht und bei sprunghafter Änderung der Impedanz das Teilnetz vom Hauptnetz abgetrennt.

Die in der Figur 1 dargestellte Schaltung ermöglicht die Zuschaltung einer Kapazität zu einem genau definiertem Zeitpunkt. Der Mikrocontroller mißt die Zeiträume zwischen den Nulldurchgängen und schaltet den Schalter zu einem bestimmten Zeitpunkt innerhalb einer Phase.

Als besonders günstig hat es sich herausgestellt, die Kapazität über den Zeitraum einer Ganzwelle eingeschaltet zu halten. Der Kondensator wird so bei einer Spannung des Netzes getrennt, bei der er bei einem nächsten Schaltzyklus wieder eingeschaltet wird, so daß keine unnötig hohen Schaltströme fließen.

Die beiden Mikrocontroller führen die Impedanzmessung unabhängig voneinander durch und überwachen alle Meßpunkte. Das Zuschalten des Kondensators wird nur von dem einen Mikrocontroller durchgeführt, wobei der zweite Mikrocontroller den Zeitpunkt des Schaltvorganges registriert. Beide Mikrocontroller bestimmen dann parallel die Netzimpedanz. Die beiden Relais werden jeweils nur von einem der beiden Mikrocontroller nach ihrer jeweiligen eigenen Analyse angesteuert.

Die Mikrocontroller sind über zwei separate Leitungen miteinander verbunden, über die sie sich gegenseitig darüber informieren, wann sie ihr Relais freischalten.

Die Zuschaltung der Relais erfolgt nur dann, wenn beide Mikrocontroller dies "erlauben". Die Abschaltung dagegen erfolgt bei beiden Mikrocontrollern, sobald auch nur einer von ihnen entsprechende Zustände feststellt.

Die Ausschaltkriterien beider Mikrocontroller sind im wesentlichen:
- Ein Netzimpedanzsprung liegt vor;
- Die Netzspannung oder die Netzfrequenz liegen im unzulässigen Bereich;
- Eine zu niedrige Versorgungsspannung erlaubt keine konkreten Messungen;
- Die Impedanzmessung-erfolgt nicht häufig genug;
- Einer der Meßwerte liegt nicht im plausiblen Bereich;
- Eines der beiden Relais schaltet nicht mehr korrekt;
- Der andere Mikrocontroller fordert die Abschaltung der Relais.

### Bezugszeichenliste:

- 1: Teilnetz
- 2: Kondensator
- 3: Relais
- 4: Relais
- 5: Gleichrichter
- 6: Gleichrichterpunkt
- 7: Eingang
- 8: Schaltorgan
- 9: Gleichrichterpunkt
- 10: Eingang der Mikrocontroller
- 11: Ausgang des ersten Mikrocontrollers
- 12: Eingang des zweiten Mikrocontrollers

## Patentansprüche

1. Verfahren zur Bestimmung einer Impedanz in Wechselstromnetzen mit folgenden Merkmalen:
- es werden elektrische Größen ermittelt und ausgewertet,
- in dem Wechselstromnetz wird ein Blindstrom derart erzeugt, daß aus dem daraus resultierenden Spannungsabfall an der Netzimpedanz der Nulldurchgang in Relation zum unbelasteten Netz zeitverschoben erfolgt,
- die Erzeugung des Blindstromes erfolgt in Intervallen,
- es wird die Phasenverschiebung der Spannung ohne Blindstrom zu der Spannung mit Blindstrom über eine Zeitmessung, die in der Nähe des Spannungsnulldurchganges beginnt bzw. endet, ermittelt,
- aus dem Zeitunterschied im belasteten und unbelasteten Fall wird die Phasenverschiebung ermittelt und
- aus der Phasenverschiebung wird mit R_{Netz} ≈ dt/I eine Netzimpedanz ermittelt.

2. Verfahren nach Anspruch 1, **dadurch gekennzeichnet**, daß zur Ermittlung der Netzimpedanz zwei Zeitmessungen vorgesehen sind.

3. Verfahren nach Anspruch 1 oder 2, **dadurch gekennzeichnet**, daß der Blindstrom durch eine parallele Einschaltung einer Kapazität oder Induktivität zum Wechselstromnetz erzeugt wird.

4. Verfahren nach Anspruch 3, **dadurch gekennzeichnet,** daß die Einschaltdauer der Kapazität oder Induktivität im wesentlichen einer Spannungsperiode entspricht.

5. Verfahren nach einem oder mehreren der Ansprüche 1 bis 4, **dadurch gekennzeichnet,** daß die Zeitmessung über die Dauer einer halben Periode der Netzspannung erfolgt.

6. Verfahren nach einem oder mehreren der Ansprüche 1 bis 5, **dadurch gekennzeichnet**, daß die erste Zeitmessung in der Nähe eines Spannungsnulldurchganges bei einer Spannung von U = + x Volts bei abgeschaltetem Blindstrom beginnt, daß nach dem Beginn der ersten Zeitmessung der Blindstrom zugeschaltet wird, daß die Zuschaltung bis zum Ende der ersten Zeitmessung aufrechterhalten bleibt, und daß die erste Zeitmessung nach einer halben Periode mit Erreichen der Spannung U = - x Volts beendet wird.

7. Verfahren nach einem oder mehreren der Ansprüche 2 bis 6, **dadurch gekennzeichnet,** daß die zweite Zeitmessung in der Nähe eines Spannungsnulldurchganges bei einer Spannung von U = +y Volts bei zugeschaltetem Blindstrom beginnt, daß nach dem Beginn der zweiten Zeitmessung der Blindstrom abgeschaltet wird, daß die Abschaltung bis zum Ende der zweiten Zeitmessung aufrechterhalten wird, und daß die zweite Zeitmessung nach einer halben Periode mit Erreichen der Spannung U = -y Volts beendet wird.

8. Verfahren zur Verhinderung von Inselnetzen bei der Einspeisung von Energie in Wechselstromnetze, bei dem eine Abtrennung eines Teilnetzes bei sprunghafter Änderung der Netzimpedanz erfolgt, **dadurch gekennzeichnet,** daß eine Impedanzüberwachung mittels einer Impedanzbestimmung nach einem oder mehreren der Ansprüche 1 bis 7 vorgesehen ist.

9. Netzüberwachungsschaltung mit:
1. einem Kondensator (2),
1.1 der parallel zu einem zu überwachenden Netz (1) geschaltet ist, und
1.2 von einem Schaltorgan (8) am Netz (1) zu- bzw. abschaltbar ist,
2. einem Mikrocontroller,
2.1 der das Schaltorgan (8) in der Nähe des Scheitelwertes der Netzspannung ansteuert,
2.2 eine Zeitmessung durchführt, die im Bereich eines Spannungsnulldurchganges der Netzspannung beginnt bzw. endet, wobei der Kondensator (2) während der Messung zu- bzw. abgeschaltet wird und
2.3 der zur Ermittlung der Phasenverschiebung die Zeitmessung auswertet, wobei aus der Phasenverschiebung die Netzimpedanz ermittelt wird.

10. Vorrichtung zur Verhinderung von Inselnetzen bei der Einspeisung von Energie in Wechselstromnetze, mit einer die Netzimpedanz erfassenden Meßvorrichtung, **dadurch gekennzeichnet,** daß die Meßvorrichtung gemäß Anspruch 9 ausgebildet ist, daß ein mit dem zu überwachenden Teilnetz (1) in Reihe geschaltetes Abschaltorgan (3; 4) vorgesehen ist, welches in Abhängigkeit der ausgewerteten Zeitmessung von dem Mikrocontroller betätigbar ist, wodurch das Teilnetz (1) vom Netz trennbar ist.

11. Vorrichtung nach Anspruch 10, **dadurch gekennzeichnet,** daß der Microcontroller derart ausgebildet ist, daß das Teilnetz (1) von einem Hauptnetz bei sprunghafter Änderung der Impedanz getrennt wird.

12. Vorrichtung nach Anspruch 10 oder 11, **dadurch gekennzeichnet,** daß zwei Mikrocontroller und zwei Abschaltorgane (3, 4) vorgesehen sind, die derart geschaltet und verbunden sind, daß die Abschaltorgane (3, 4) von je einem Mikrocontroller angesteuert werden, daß die beiden Mikrocontroller unabhängig voneinander die Impedanzbestimmung durchführen und daß der erste Mikrocontroller das Zuschalten durchführt und der zweite Mikrocontroller den Zeitpunkt des Zuschaltens registriert.

## Claims

1. Process to determine impedance in an a.c. network with the following features:
- electrical quantities are calculated and evaluated,
- a reactive current is generated in the a.c. network so that the zero passage is time-delayed in relation to an unloaded network from the resulting voltage drop from network impedance,
- the reactive current is generated at intervals,
- the phase shift of the voltage without reactive current to the voltage with reactive current is calculated by a time measurement that begins or ends close to the passage of voltage through zero,
- the phase shift is calculated from the time difference between the loaded and unloaded state, and
- the network impedance is calculated from the phase shift using the formula: R_{network} ∼ dt/l.

2. A process according to claim 1, characterized in that two time measurements are used to calculate the network impedance.

3. A process according to claims 1 or 2, characterized in that the reactive current is generated by a tuming on a capacitor or inductor parallel-connected to the a.c. network.

4. A process according to claim 3, characterized in the period for which the capacitance or inductance or is switched on essentially corresponds to a voltage period.

5. A process according to one or more of claims 1-4, characterized in that the time is measured for one-half period of the network voltage.

6. A process according to one or more of claims 1-5, characterized in that the first time measurement occurs close to the passage of the voltage through zero at a voltage of U = +x Volts when the reactive current is shut off; the reactive current Is switched on after the beginning of the first time measurement; the reactive current remains switched on to the end of the first time measurement; and the first time measurement is terminated after a half period when the voltage U = -x Volts is reached.

7. A process according to one or more of claims 2-6, characterized in that the second time measurement occurs close to the passage of the voltage through zero at a voltage of U = +y Volts when the reactive current is switched on; the reactive current is switched off after the start of the second time measurement; the reactive current remains switched off up to the end of the second time measurement; and the second time measurement ends after a half period when voltage U = -y Volts.

8. A process to prevent island networks when feeding energy into a.c. networks whereby a partial network is separated after a sudden change in the network impedance, characterized in that the impedance is monitored by being measured according to one or more of claims 1-7.

9. A network monitoring circuit with:
1. A capacitor (2),
1.1 that is parallel-connected to a monitored network (1), and
1.2 can be turned off or on by a switching member (8) in the network (1),
2. a Microcontroller,
2.1 that controls the switching organ (8) close to the peak of the network voltage,
2.2 that carries out a time measurement which ends or begins as the network voltage passes through zero, whereby the capacitor (2) is switched off or on during measurement, and
2.3 that evaluates the time measurement to determine the phase shift, whereby the network impedance is calculated from the phase shift.

10. A device to prevent island networks from forming when feeding energy into a.c. networks with a measuring device that measures the network impedance, characterized in that the measuring device is designed according to claim 9, that a switching organ (3, 4) is provided which is series-connected to the partial network (1) to be monitored and which can be activated by the microcomputer depending on the evaluated time measurement, and the partial network (1) can be separated from the network.

11. A device according to claim 10, characterized in that the microcontroller is designed so that the partial network (1) is separate from a main network when the impedance suddenly changes.

12. A device according to claims 10 or 11, characterized in that two microcontrollers and two shutoff organs (3, 4) are provided that are connected such that the shut-off organs (3, 4) are each controlled by one microcontroller; the two microcontrollers measure the impedance independently; the first microcontroller is in charge of switching on, and the second microcontroller registers the time of switching on.

## Revendications

1. Procédé permettant de déterminer une impédance dans des réseaux à courant alternatif, et répondant aux caractéristiques suivantes :
- on calcule et on exploite des grandeurs électriques,
- dans le réseau à courant alternatif, on génère un courant déwatté de telle sorte que sur la base de la chute de tension qui en résulte au niveau de l'impédance du réseau, le passage par zéro se fait avec un décalage dans le temps par rapport au réseau non chargé,
- la génération du courant déwatté s'effectue par intervalles,
- on calcule le déphasage de la tension sans courant déwatté par rapport à la tension avec courant déwatté via un chronométrage qui commence et se termine au voisinage du passage de la tension par zéro,
- à partir de la différence de temps dans le cas chargé et non chargé, on détermine le déphasage et
- à partir du déphasage, on calcule avec R_{Netz} ≈ dt/l une impédance de réseau.

2. Procédé suivant la revendication 1, caractérisé en ce que pour déterminer l'impédance de réseau, on a prévu deux chronométrages.

3. Procédé suivant la revendication 1 ou 2, caractérisé en ce que le courant déwatté est généré par un enclenchement d'une capacitance ou d'une inductance en parallèle avec le réseau à courant alternatif.

4. Procédé suivant la revendication 3, caractérisé en ce que la durée d'enclenchement de la capacitance ou de l'inductance correspond substantiellement à une période de tension.

5. Procédé suivant une ou plusieurs des revendications 1 à 4, caractérisé en ce que le chronométrage s'effectue sur la durée d'une demi-période de la tension de réseau.

6. Procédé suivant une ou plusieurs des revendications 1 à 5, caractérisé en ce que le premier chronométrage commence au voisinage d'un passage de la tension par zéro, pour une tension de U = + x volts, le courant déwatté étant coupé, en ce qu'après le début du premier chronométrage le courant déwatté est établi, en ce que l'établissement reste maintenu jusqu'à la fin du premier chronométrage, et en ce qu'on met fin au premier chronométrage après une demi-période, à l'atteinte de la tension U = - x volts.

7. Procédé suivant une ou plusieurs des revendications 2 à 6, caractérisé en ce que le second chronométrage commence au voisinage d'un passage de la tension par zéro, pour une tension de U = + y volts, le courant déwatté étant établi, en ce qu'après le début du second chronométrage le courant déwatté est coupé, en ce que la coupure maintenue jusqu'à la fin du second chronométrage, et en ce qu'on met fin au second chronométrage après une demi-période, à l'atteinte de la tension U = - y volts.

8. Procédé permettant d'éviter des réseaux d'îlots lors de l'injection d'énergie dans des réseaux à courant alternatif, suivant lequel une séparation d'un sous-réseau lors d'un changement brusque de l'impédance du réseau, caractérisé en ce qu'on a prévu une surveillance de l'impédance par le biais d'une détermination de l'impédance suivant une ou plusieurs des revendications 1 à 7.

9. Circuit de surveillance du réseau, comprenant
1. un condensateur (2),
1.1 qui est mis en circuit parallèlement à un réseau (1) à surveiller, et
1.2 qui peut être mis en circuit et hors circuit par un organe de manoeuvre (8) situé dans le réseau (1),
2. un microcontrôleur,
2.1 qui enclenche l'organe de manoeuvre (8) au voisinage d'une valeur de crête de la tension de réseau,
2.2 qui accomplit un chronométrage qui commence et se termine aux alentours d'un passage de la tension de réseau par zéro, le condensateur (2) étant mis en circuit et hors circuit pendant la mesure,
2.3 qui exploite le chronométrage en vue de calculer le déphasage, l'impédance du réseau étant calculée à partir du déphasage.

10. Dispositif permettant d'éviter des réseaux d'îlots lors de l'apport d'énergie dans dès réseaux à courant alternatif, comprenant un dispositif de mesure détectant l'impédance du réseau, caractérisé en ce que le dispositif de mesure est configuré en accord avec la revendication 9, et en ce qu'on a prévu un organe de coupure (3; 4) qui est monté en série avec le sous-réseau (1) à surveiller et est manoeuvrable par le microcontrôleur en fonction de l'exploitation du chronométrage, ce qui rend le sous-réseau (1) séparable du réseau.

11. Dispositif suivant la revendication 10, caractérisé en ce que le microcontrôleur est configuré de façon à ce que le sous-réseau (1) soit séparé d'un réseau principal en cas de changement brusque de l'impédance.

12. Dispositif suivant la revendication 10 ou 11, caractérisé en ce qu'on a prévu deux microcontrôleurs et deux organes de coupure (3, 4) qui sont mis en circuit et connectés de façon à ce que les organes de coupure (3, 4) soient commandés chacun par un microcontrôleur, en ce que les deux de l'impédance indépendamment l'un de l'autre, et en ce que le premier microcontrôleur opère l'enclenchement microcontrôleurs accomplissent la détermination et le second microcontrôleur enregistre le moment de l'enclenchement.
